(19) Europäisches Patentamt
European Patent Office
Office européen des brevets

(11) **EP 4 733 117 A1**

(12) **EUROPEAN PATENT APPLICATION**

(43) Date of publication:
**29.04.2026 Bulletin 2026/18**

(21) Application number: **24315494.5**

(22) Date of filing: **24.10.2024**

(51) International Patent Classification (IPC):
**B60L 3/00** (2019.01)    **B60L 53/30** (2019.01)
**G01R 27/18** (2006.01)

(52) Cooperative Patent Classification (CPC):
**B60L 3/0069; B60L 3/0046; B60L 3/04; B60L 3/12;
B60L 53/11; B60L 53/14; B60L 53/305;
B60L 53/62; B60L 53/66; G01R 27/18**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Watt & Well
84120 Pertuis (FR)**

(72) Inventors:
• **Iglesias, Raul
92160 ANTONY (FR)**
• **Calamote, Jean-Christophe
78150 LE CHESNAY (FR)**
• **Alami, Abdesslam
91120 PALAISEAU (FR)**

(74) Representative: **IXAS Conseil
22, avenue René Cassin
69009 Lyon (FR)**

(54) **A SUPPLY EQUIPMENT COMMUNICATION CONTROLLER MODULE IN A CHARGING STATION FOR BATTERIES**

(57)    In a charging station (22) for electric batteries (21), a supply equipment communication controller module (24) monitoring the charging process between the power module (23) and a supervisor module (25) integrates an insulation monitoring device (29) and a manager (19) thereof for repeatedly estimating insulation resistances between the poles (DC+, DC-) of the battery, and the charging conductors (27, 28) with respect to the earth (PE). The device (29) replaces conventional, separate apparatus which must be plugged to the battery and involve cumbersome measurements. In preferred embodiments, the device (29) cooperates with a measurement chain for the voltages of the poles with very little hardware added, which may consist in an electric discharge branch connecting the measurement chain to the earth, and comprising a resistor and a switchable switch.

Fig. 2

**Description**

Field of the invention

This invention relates to a supply equipment communication controller module (generally abridged to SECC module, or even SECC) in a charging station for batteries, for instance batteries equipping electric vehicles.

Technological background

In electrical charging stations, the SECC modules are combined with power modules supplying the electrical energy to the batteries, for monitoring the charging process and react to particular events and hazards.

The insulation status of the battery poles with respect to an electrical earth called protective earth is one of the parameters that must be monitored. An insufficient insulation may result from a damp charging cable, although other causes exist. A warning must be issued when the value of any one of the overall resistances between the electrical potential of the poles and the electrical earth is found below a first threshold value, and the charging process must even be interrupted when this value is found below a second, lower threshold value.

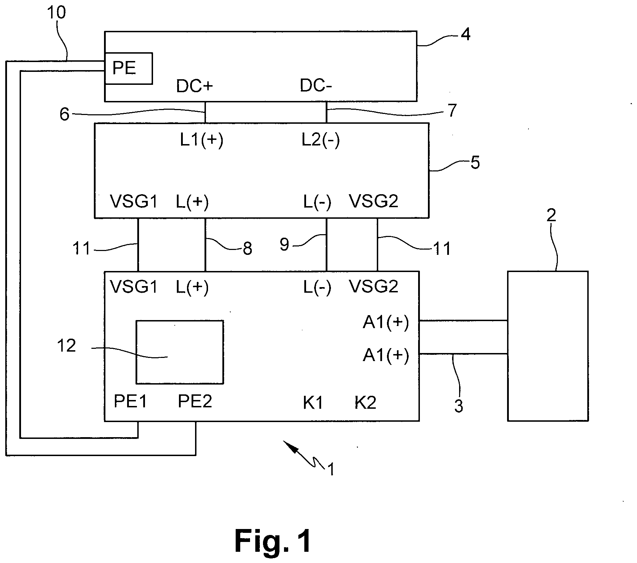

The values of these resistances are conventionally sensed by insulation monitoring devices which are independent apparatus making active measurements. A schematic illustration of a widespread example of such apparatus is made in Figure 1. Electrical energy is supplied to the conventional insulation monitoring device 1, separate from the SECC module of the charging station, by a direct current supply 2 through a pair of wires 3, and the insulation monitoring device 1 senses an equipment under test 4 through a coupling device 5. The coupling device 5 is often necessary for adapting the electrical potentials of the equipment under test 4 when they are at too high levels. Poles DC+ and DC- of the equipment under test 4 are connected to the coupling device 5, when it must be present, by respective wires 6 and 7, their electrical potentials are indirectly transmitted to the insulation monitoring device 1 by other wires 8 and 9, while the electrical potential of the protective earth is communicated to the insulation monitoring device 1 directly by wires 10. Further wires 11 must generally be added between the insulation monitoring device 1 and the coupling device 5 for enabling their cooperation. The measurements of the resistances between the poles DC+ and DC- and the protective earth appear on a display 12 of the insulation monitoring device 1. This addition of external, plug-in means to the charging station is clearly cumbersome, even when the coupling 5 need not be added to the arrangement.

Summary of the invention

An object of the invention is therefore to improve the general arrangement of electrical charging stations by a different design of the insulation monitoring device.

Another object of the invention is to avoid cumbersome equipment that must be plugged in to the equipment under test and the SECC module for enabling the insulation measurements.

A third object of the invention is to simplify, and making more reliable, the insulation measurements.

A fourth object of the invention is to store the measurements by the insulation measurement device in a memory of the SECC so that it can be retrieved with any other useful information, for instance for confirming a faulty state of the charging process.

According to a main definition, the invention consists in an improved supply equipment communication controller module, which integrates an insulation monitoring device for sensing resistances between poles of a battery to be charged and an electrical earth.

The advantage is twofold: the SECC hardware needs little modification for enabling the insulation measurements, and the measurements can be made quickly and easily. The insulating measurements are passive, i.e. without any plug-in or manual connection of other apparatus. The measurements can be made at any moment by automatised routines. Further, their results are easily managed by the SECC.

These advantages are most noticeable if the insulation monitoring device is integrated in a direct current, high voltage measurement chain, already present in the SECC module for measuring electrical potentials of said poles: by exploiting the measurement chain and the measurements of these electrical potentials, the insulation resistance may be computed easily and with very little hardware added.

A still greater integration is obtained if an insulation monitoring device manager, which comprises means for computing said insulation resistances between the poles and the electrical earth, is integrated in the supply equipment communication controller too.

Advantageously, the means for computing use measurements of the electrical potentials of the poles made by the direct current, high voltage measurement chain.

In important embodiments of the invention, the direct current, high voltage measurement chain comprises:

- an electric line having ends respectively connected to said poles and composed of a positive side and a negative side, the positive side and the negative side joining at an electrical connection to the electrical earth;

- the positive side comprising a first data acquisition resistor and a first voltage measurer for providing the electrical potential of a first one of the poles, the negative side comprising a second voltage measurer for providing the electrical potential of a second one of the poles and a second data acquisition resistor;

- and the insulation monitoring device comprises: a first electric discharge branch having ends respectively connected to the positive side of the electric line, between the first pole and the first data acquisition resistor, and to the electrical earth, and comprising a switch and a discharge resistor; and a second electric discharge branch having ends respectively connected to the negative side of the electric line, between the second data acquisition resistor and the second pole, and to the electrical earth, and comprising a switch and a discharge resistor.

The first electric discharge branch and the second electric discharge branch are advantageously identical. Also, the positive side and the negative side of the electric line are advantageously identical.

The insulation measurement device manager may comprise switch control means for alternatively closing and opening the switches of the first and the second electric discharge branches.

The insulation monitoring device manager may also comprise means for selecting either the first electric discharge branch or the second electric discharge branch to be closed, for computing one of the insulation resistances.

Said one of the insulation resistances may be computed according to formulae

$$REQ = R0 * \{ [VDC\text{-}(1) * VDC\text{+}(2) / (VDC\text{+}(1) * VDC\text{-}(2)] - 1 \}$$

and

$$RISO = REQ * (R1 + R2) / [ (R1 + R2) - REQ ].$$

in which R0 is the value of the discharge resistor in the selected electric discharge branch; R1 and R2 are, in the side of the electric line to which the selected electric discharge branch is connected, values of the data acquisition resistor and of a resistor shunting the voltage measurer; VDC+(1) and VDC-(1) are voltage values respectively measured by the first and the second voltage measurer when the switch of the selected electric discharge branch is open; VDC+(2) and VDC-(2) are voltage values respectively measured by the first and the second voltage measurer when the switch of the selected electric discharge branch is closed; and RISO is the value of said one of the insulation resistances, which corresponds to the side of the electric line to which the electric discharge branch which is not selected is connected.

Further optional characteristics of the invention include:

- the means for computing comprise at least one criterion for discarding measurements intended for computing said insulation resistances but having values considered as unreliable;

- the at least one criterion comprises a model voltage ramp increasing with charging time and a voltage threshold, said measurements being discarded when a difference between their value and the voltage ramp has an absolute value superior to the voltage threshold;

- the at least one criterion comprises another voltage threshold, the model voltage ramp being corrected by a constant amount when a difference between the value of said measurements and the voltage ramp has an absolute value superior to said another voltage threshold.

Short description of the figures

The characteristics, purposes and advantages of the invention will now be exposed more in detail with the help of the following figures, of which figures 2 to 6 disclose a preferred embodiment of the invention, in a purely illustrative way only, while figure 1 illustrates a prior art:

- Figure 1 (already described) illustrates a conventional device comprising an external, plugged-in insulation monitoring device;

- Figure 2 illustrates the main components of an electrical charging station, comprising a supply equipment communication controller according to the invention;

- Figure 3 illustrates the direct current, high voltage measurement chain and the integrated insulation monitoring device of the inventive supply equipment communication controller;

- Figure 4 is a diagram showing the general method for computing the insulation resistance;

- Figure 5 is a plot indicating how measurements are taken into account, or cancelled;

- Figure 6 is a diagram showing the detail of computations of the insulation resistance.

Detailed description of the invention

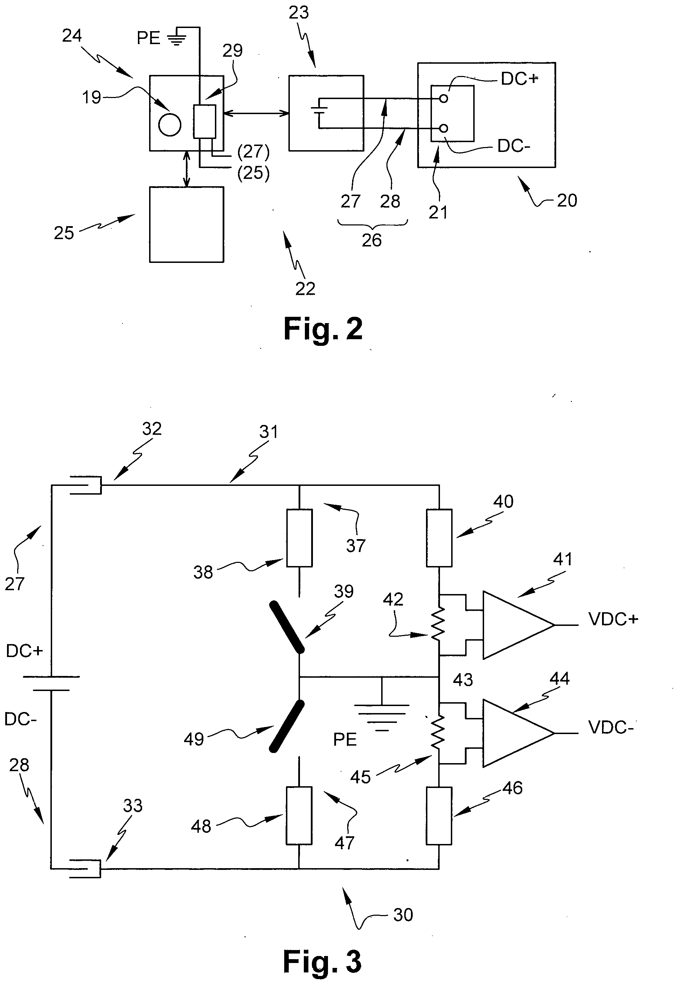

Figure 2 will be described now. An electric vehicle 20 comprises a battery 21 having a positive pole DC+ and a negative pole DC-. A charging station 22 comprises a power module 23, a supply equipment communication controller (SECC) 24 and a supervisor 25 which comprises a software for managing the charging station 22, and possibly a man-machine interface. The SECC 24 is connected to the power module 23 and to the supervisor 25 so that the SECC 24 monitors the charging process and issues warnings to the supervisor 25, or interrupts the process, when malfunctions occur. A charging cable 26 links the power module 23 and the battery 21 and comprises two conductors 27 and 28 leading to the positive and negative poles DC+ and DC- respectively.

According to the invention, the SECC 24 comprises an insulation monitoring device 29 integrated therein, as well as an insulation monitoring device manager 19. The integration means that the insulation monitoring device 29 and the insulation monitoring device manager 19 are not physically separable from the remainder of the SECC 24. Since the SECC 24 often consists in a board carrying processors and other electronic equipment, the equipment characterising the insulation monitoring device 29 and the insulation monitoring device manager 19 will be borne by this board. But the degree of integration is actually deeper in the instant embodiment, because it takes advantage of an equipment of the SECC 24 already used for another measurement, for contributing to the determination of the insulation resistances. In other words, the components specific to the insulation measurement device 29 are connected to the components of this other equipment and cooperate with them.

This is explained in Figure 3. The SECC 24 comprises a measurement chain 30, in which an electric line 31 is continuous between ends 32 and 33 connected to the conductors 27 and 28 respectively. The electric line 31 comprises, from end 32 to end 33:

- at a positive side of the measurement chain 30, a first or positive electric discharge branch 37 carrying a resistor 38 and a switch 39 in series, and leading to the protective earth PE;

- a first main resistor 40;

- a first voltage measurer 41, with a shunt resistor 42:

- a connection 43 to the protective earth PE;

- and a symmetrical arrangement at a negative side of the measurement chain 30, successively comprising a second voltage measurer 44 with a shunt resistor 45, a second main resistor 46, a second or negative electric discharge branch 47, and a connection of a second earthing line 49. The negative electric discharge branch 47 also comprises a resistor 48 and a switch 49 in series and leading to the electrical potential. The corresponding components are advantageously identical. For instance, the first and second main resistors 40 and 46 have same values, and the same applies to resistors 38 and 48. The switches 39 and 49 consist, in this embodiment, of solid state relays switched by energising circuits not shown and known in the art. Each of the voltage measurers 41 and 44 comprises two input lines each, both the input lines are connected to the electric line 31 on either side of the respective shunt resistor 42 or 45.

With the exception of the positive and negative electric discharge branches 37 and 47, all these components are designed for measuring the electrical potentials of the poles DC+ and DC-, and they belong to a so-called direct current, high voltage (HVDC) section of the SECC 24. The measurements VDC+ and VDC- with respect to the protective earth of these electrical potentials are provided at the respective output lines of the voltage measurers 41 and 44. Thus, the insulation monitoring device 29 is composed of the electric discharge branches 37 and 47, which cooperate with this HVDC section.

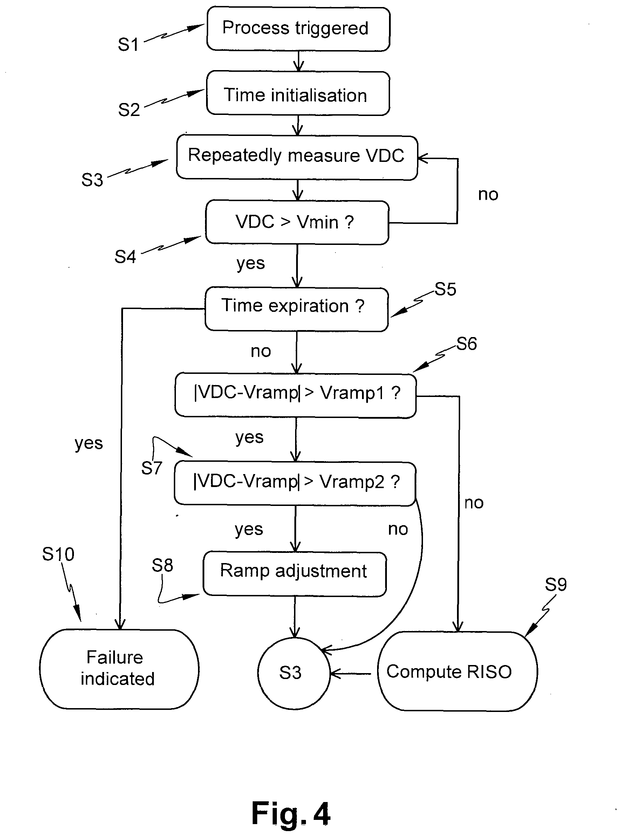

The electric charging circuit is considered as having an overall resistance, called an insulation resistance RISO+, between the pole DC+ and the protective earth PE, and another insulation resistance RISO- between the other pole DC- and- the protective earth PE. They should not dwindle under specified values for safety reasons. The operation of the SECC 24 for determining these insulation resistances RISO will be described now with reference to Figure 4. It is performed with the help of the insulation monitoring device manager 19, which may consist in a processor, integrated in the SECC 24 like the insulation monitoring device 29 itself, and which may also include software like switch controller means for controlling the switches 39 and 49, computing means for obtaining the values of the insulation resistances, and selecting means for cancelling some measurements, as described hereunder.

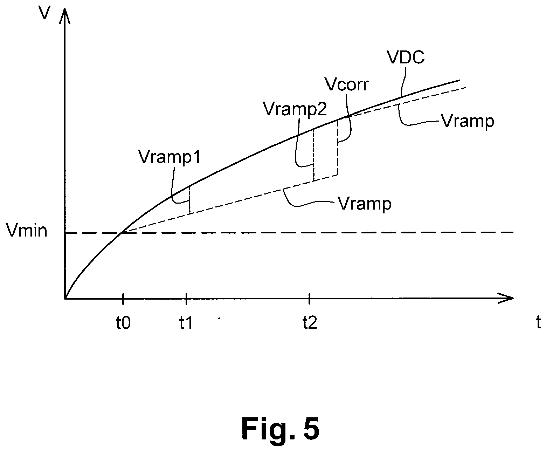

A computation of the insulation resistances RISO is triggered (step S1) automatically at regular times. Both the switches 39 and 49 are open at the beginning of the process. A time counter is initialised (step S2), the voltage measurers 41 and 44 are repeatedly sampled, and successive values of the measured values of VDC+ and VDC- are stored at step S3. However, the algorithm is devised to discard noisy or unreliable measurements. In a following step S4, it is checked whether the sum VDC of the measurements VDC+ and VDC- (VDC+ + VDC- = VDC) is greater than a first threshold Vmin corresponding to a lower operation limit of the insulation monitoring device 29 (Figure 5). If they are greater, the algorithm progresses to the following steps, otherwise a reset is done, the algorithm returns to step S3, and the previous measurements, considered as irrelevant, are not processed. Further, the evolution of the measurements of the sum VDC is surveyed. The measurements are compared to a preset voltage ramp Vramp representative of a normal charging process and having a moderate slope according to time (t). In a next step S6, it is checked whether the absolute value | VDC - Vramp | becomes greater than a second threshold Vramp1 at any moment. If this absolute value is smaller, the measurements of the sum VDC are considered to be fitting for a computation of the insulation resistances RISO+ and RISO-, and the program goes to step S9 and may engage this computation. If it is greater, an abnormal charge process may be present, and there is no computation of the insulation resistances at this time. However, if the difference | VDC - Vramp | is greater than a third threshold Vramp2 (step S7), the voltage ramp Vramp will be adjusted (step S8) by adding or subtracting a value Vcorr so that the voltage ramp Vramp is displaced and coincides with the VDC measurement at this moment (VDC = Vramp + Vcorr), while remaining at the same slight slope. This correction will enable a better match of the model charging function embodied by the voltage ramp Vramp and the actual measurements VDC, so that the computations of the insulation resistances RISO will not be excessively delayed in the circumstances of a normal charging process, in which the slope of the measurements VDC will converge to the slope of Vramp. After S7, or S8 when this is necessary, the program returns to step S3 and the measurements of the sum VDC are resumed. Also, the program returns to step S3 when the insulation resistance is computed and step S9 has ended, in order to repeatedly update the computation.

Figure 5 illustrates these different possible states of the measuring process, when the sum VDC of the measured voltages VDC+ and VDC- has reached the minimal voltage Vmin at instant t0, and the insulation monitoring device 29 become active. The voltage ramp being applied from this instant, the difference between Vramp and VDC reaches Vramp1 and Vramp2 at later instants t1 and t2 respectively in this particular illustration, and Vcorr is applied shortly after Vramp2 has been found. As already explained, the computation of the resistances RISO+ and RISO- is interrupted between instants t1 and t2.

Should however the charge process remain unstable, a warning of failure to compute the insulation resistances will be issued after a preset expiration time has elapsed. The process may comprise a step S5 between steps S4 and S6, which consists in reading the time counter (initialised at step S2). If the expiration time has been reached, the warning is issued at step S10, the computation process is interrupted, and it will be resumed later with a reset to step S1.

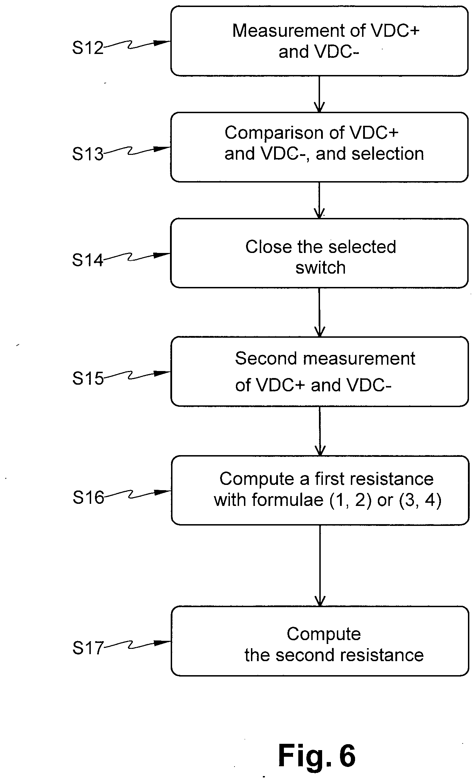

Step S9 will now be disclosed in detail with reference to Figure 6.

A first measurement of the electrical potentials VDC+(1) and VDC-(1) of the battery poles is made at a same instant (1) by the voltage measurers 41 and 44 (step S12), and the corresponding values are stored.

These values VDC+(1) and VDC-(1) and compared (step S13). According to the result of the comparison, one of the switches 39 and 49 is selected and closed (S14).

The comparison in step S13 and the selection in step S14 are made as follows. If VDC+(1) > VDC-(1) (or more generally [VDC+(1) - PE] > [PE - VDC-(1)] if it is not assumed that the earth potential is zero) it is stated that the impedance is lower in the negative side of the measurement chain 30, so RISO- is lower than RISO+ and will be critical so that it will be computed first. Further, the switch 39 in the positive electric discharge branch 37 is selected and closed.

In the next step (S15), a second measurement of the electrical potentials VDC+(2) and VDC-(2) is made at an instant (2), when the selected switch 39 has just been closed.

The computation of the insulation resistances RISO+ and RISO-becomes possible and is made in the following steps (S16 and S17).

RISO- is determined in step 16 by applying formulae {1} and {2}:

$$\{1\}\ REQ\_N = R0\ *\{\ [VDC\text{-}(1)\ *\ VDC\text{+}(2)\ /\ (VDC\text{+}(1)\ *\ VDC\text{-}(2)]\ -\ 1\}$$

then

$$\{2\}\ RISO\text{-} = REQ\_N\ *\ (R1 + R2)\ /\ [\ (R1 + R2)\ -\ REQ\_N\ ],$$

in which R0 is the value of the resistor 38 in the positive electric discharge branch 37, R1 the value of the main resistor 40, and R2 the value of the shunt resistor 42 in the positive side of the measurement chain 30.

RISO+ can easily be computed in the last step 17. Since the electric circuit may be considered as consisting of the two insulation resistances RISO+ and RISO- between the poles DC+ and DC-, VDC+ and VDC- have been measured and RISO- has just been computed, a voltage division operation RISO+ = RISO- (VDC+ / VDC-) becomes possible, both the switches 39 and 49 being openned for this.

It is valuable to close the switch 39 or 49 associated to the side (here, the switch 39 associated to the positive side) having the greater impedance. The perturbation of the electrical balance brought about by the switching operation is greater, the effects of noise in the measurements are smaller, and the computations are more accurate.

If conversely VDC+ < VDC-, the impedance is lower in the positive side of the measurement chain 30, and the insulation resistance RISO+, being lower than RISO-, is preferably computed. Steps S14 to S17 are performed as follows. The switch 49 in the negative electric discharge branch 47 is selected and closed, and the modified values of VDC+(2) and VDC-(2) are measured and stored in step S15. The computations in step S16 consist of:

$$(3)\ REQ\_P = R0\ *\{\ [VDC\text{-}(1)\ *\ VDC\text{+}(2)\ /\ (VDC\text{+}(1)\ *\ VDC\text{-}(2)]\ -\ 1\}$$

then

$$(4)\ RISO\text{+} = REQ\_P\ *\ (R1 + R2)\ /\ [\ (R1 + R2)\ -\ REQ\_P\ ].$$

in which R0 is the value of the resistor 48 in the negative electric discharge branch 47, R1 the value of the main resistor 46, and R2 is the value of the shunt resistor 45 in the negative side of the measurement chain 30.

The voltage division in step S17 therefore consists in RISO- = RISO+ (VDC- / VDC+) in this situation, both the switches 39 and 49 being opened.

The rationale of the method can be explained as follows. The insulation resistances RISO+ and RISO- correspond to all the resistances separating the ends 32 and 33 from the protective earth PE. The voltage distribution along the measurement chain 30 can be expressed by an equation f(VDC+, VDC-, RISO+, RISO-). VDC+(1) and VDC-(1) being measured at the voltage measurers 41 and 44, two unknown variables (RISO+ and RISO-) remain. The insertion of the resistor 38 or 48 into the system introduces a disparity in the voltage distribution according to a second equation with the same unknown variables. When VDC+(2) and VDC-(2) are measured in the new configuration of the measurement chain 30, the system of the two equations can be solved.

Another advantage of the integration of the insulation measurement device 19 in the SECC 24 consists in that the measurements made in steps S12 and S15 are stored and can be retrieved with other measurements by the SECC 24 when this is wanted, if any fault has been diagnosed. The access to past measurements will help the operator to conclude whether, for instance, the cable is really damaged or otherwise unable to perform its function, or the measurements were rather spoilt by noise and the material is convenient. Further, the common timing for the insulation measurement device and the SECC 24 will enable to correlate the voltage measurements by the insulation measurement device 19 with any other information delivered by the SECC 24. This easy access and exploitation of the memory of the insulation measurement device 19 is not available in conventional installations with a plugged-in apparatus.

This new architecture of the supply equipment communication controller with an integrated insulation monitoring device involves a series of advantages over the suppression of separate, plugged-in devices. The use of an existing circuit (the measurement chain 30) enables to hardly complicate the existing SECCs for computing the insulation resistance. The measurements allowed by the integrated insulation measurement device 29 are easily triggered, do not require great care from the operator; they can be stored easily, and exploited directly by the insulation measurement device manager 19 which is also integrated in the SECC 24 and in which data characterising the insulation measurement device 29 are logged. The computations can be performed within few seconds either in real charging processes or autotests. The SECC 24 can be adapted to a number of combinations of batteries 21 and charging stations 22.

## Claims

1. A supply equipment communication controller module (24), **characterised in that** it integrates an insulation monitoring device (29) for sensing insulation resistances (RISO+, RISO-) between poles (DC+, DC-) of a battery (21) to be charged and an electrical earth (PE).

2. The supply equipment communication controller according to claim 1, **characterised in that** the insulation monitoring device is integrated in a direct current, high voltage measurement chain (30) of the supply equipment communication controller module (24), for measuring electrical potentials (VDC+, VDC-) of said poles.

3. The supply equipment communication controller according to any one of claims 1 or 2, **characterised in that** it comprises an insulation monitoring device manager (19), which is integrated in the supply equipment communication controller (24) too and comprises means for computing said insulation resistances between the poles and the electrical earth.

4. The supply equipment communication controller according to claims 2 and 3, **characterised in that** the means for computing use measurements of the electrical potentials (VDC+, VDC-) of the poles made by the direct current, high voltage measurement chain (30).

5. The supply equipment communication controller according to any one of claims 2 or 4, **characterised in that** the direct current, high voltage measurement chain (30) comprises:

    - an electric line (31) having ends (32, 33) respectively connected to said poles and composed of a positive side and a negative side, the positive side and the negative side joining at an electrical connection (43) to the electrical earth (PE);
    - the positive side comprising a first data acquisition resistor (40) and a first voltage measurer (41) for providing the electrical potential of a first one of the poles (DC+), the negative side comprising a second voltage measurer (44) for providing the electrical potential of a second one of the poles (DC-) and a second data acquisition resistor (46),
    - and the insulation monitoring device (29) comprises: a first electric discharge branch (37) having ends respectively connected to the positive side of the electric line, between the first pole (DC+) and the first data acquisition resistor (40), and to the electrical earth (PE), and comprising a switch (39) and a discharge resistor (38); and a second electric discharge branch (47) having ends respectively connected to the negative side of the electric line, between the second data acquisition resistor (46) and the second pole (DC-), and to the electrical earth, and comprising a switch (49) and a discharge resistor (48).

6. The supply equipment communication controller according to claim 5, **characterised in that** the first electric discharge branch and the second electric discharge branch (37, 47) are identical.

7. The supply equipment communication controller according to claim 6, **characterised in that** the positive side and the negative side of the electric line (31) are identical.

8. The supply equipment communication controller according to claims 3 and 5, **characterised in that** the insulation measurement device manager (19) comprises switch control means for alternatively closing and opening the switches (39, 49) of the first and the second electric discharge branches.

9. The supply equipment communication controller according to claims 3 and 5, **characterised in that** the insulation monitoring device manager (19) comprises means for selecting either the first electric discharge branch or the second electric discharge branch (37, 47) to be closed, for computing one of the insulation resistances.

10. The supply equipment communication controller according to claim 9, **characterised in that** said one of the insulation resistances is computed according to formulae

$$REQ = R0 *\{[VDC\text{-}(1) * VDC\text{+}(2) / (VDC\text{+}(1) * VDC\text{-}(2)] - 1\}$$

and

$$RISO = REQ * (R1 + R2) / [ (R1 + R2) - REQ].$$

in which R0 is the value of the discharge resistor in the selected electric discharge branch; R1 and R2 are, in the side of the electric line (31) to which the selected electric discharge branch is connected, values of the data acquisition resistor (40, 46) and of a resistor (42, 45) shunting the voltage measurer (41, 44); VDC+(1) and VDC-(1) are voltage values respectively measured by the first and the second voltage measurer when the switch of the selected electric discharge branch is open; VDC+(1) and VDC+(2) are voltage values respectively measured by the first and the second voltage measurer when the switch of the selected electric discharge branch is closed; and RISO is the value of said one of the insulation resistances, which corresponds to the side of the electric line (31) to which the electric discharge branch which is not selected is connected.

11. The supply equipment communication controller according to at least claim 3, **characterised in that** the means for computing comprise at least one criterion for discarding measurements intended for computing said insulation resistances but having values considered as unreliable.

12. The supply equipment communication controller according to claims 4 and 11, **characterised in that** the at least one criterion comprises a model voltage ramp (Vramp) increasing with charging time and a voltage threshold (Vramp1), said measurements being discarded when a difference between their value and the voltage ramp has an absolute value superior to the voltage threshold.

13. The supply equipment communication controller according to claim 12, **characterised in that** the at least one criterion comprises another voltage threshold (Vramp2), the model voltage ramp (Vramp) being corrected by a constant amount when a difference between the value of said measurements and the voltage ramp has an absolute value superior to said another voltage threshold.

**Fig. 1**

**Fig. 2**

**Fig. 3**

**Fig. 4**

**Fig. 5**

S12 → Measurement of VDC+
and VDC-

S13 → Comparison of VDC+
and VDC-, and selection

S14 → Close the selected
switch

S15 → Second measurement
of VDC+ and VDC-

S16 → Compute a first resistance
with formulae (1, 2) or (3, 4)

S17 → Compute
the second resistance

**Fig. 6**

# EP 4 733 117 A1

European Patent Office

Europäisches Patentamt
European Patent Office
Office européen des brevets

## EUROPEAN SEARCH REPORT

**Application Number**

EP 24 31 5494

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/283216 A1 (SAGLAM USTUN [SE] ET AL) 8 September 2022 (2022-09-08) | 1-11 | INV.<br>B60L3/00 |
| Y | * paragraph [0006] - paragraph [0038]; figures 4,5 * | 12,13 | B60L53/30<br>G01R27/18 |
| | ----- | | |
| X | US 2020/200833 A1 (MAYER FLORIAN [DE] ET AL) 25 June 2020 (2020-06-25) | 1-11 | |
| A | * paragraph [0002] - paragraph [0078]; figures 1,2,3,4 * | 12,13 | |
| | ----- | | |
| Y | US 2023/152358 A1 (WEYEN DOMINIQUE [BE] ET AL) 18 May 2023 (2023-05-18)<br>* paragraph [0077] - paragraph [0088]; figure 3b * | 12,13 | |
| | ----- | | |

|  |
|---|
| **TECHNICAL FIELDS SEARCHED (IPC)** |
| B60L<br>G01R<br>H01M<br>H04B |

The present search report has been drawn up for all claims

| Place of search | Date of completion of the search | Examiner |
|---|---|---|
| The Hague | 10 April 2025 | Cuk, Vladimir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 31 5494

This annex lists the patent family members relating to the patent documents cited in the above-mentioned European search report.
The members are as contained in the European Patent Office EDP file on
The European Patent Office is in no way liable for these particulars which are merely given for the purpose of information.

10-04-2025

| Patent document cited in search report | Publication date | Patent family member(s) | | Publication date |
|---|---|---|---|---|
| US 2022283216 A1 | 08-09-2022 | CN | 115027298 A | 09-09-2022 |
| | | EP | 4052948 A1 | 07-09-2022 |
| | | US | 2022283216 A1 | 08-09-2022 |
| US 2020200833 A1 | 25-06-2020 | CN | 111051901 A | 21-04-2020 |
| | | DE | 102017119992 A1 | 28-02-2019 |
| | | US | 2020200833 A1 | 25-06-2020 |
| | | WO | 2019043063 A1 | 07-03-2019 |
| US 2023152358 A1 | 18-05-2023 | CN | 113678334 A | 19-11-2021 |
| | | DK | 3675302 T3 | 10-05-2021 |
| | | EP | 3675302 A1 | 01-07-2020 |
| | | JP | 7637363 B2 | 28-02-2025 |
| | | JP | 2022524264 A | 02-05-2022 |
| | | PL | 3675302 T3 | 06-09-2021 |
| | | US | 2023152358 A1 | 18-05-2023 |
| | | WO | 2020136157 A1 | 02-07-2020 |

EPO FORM P0459

For more details about this annex : see Official Journal of the European Patent Office, No. 12/82